# EUROPÄISCHE PATENTSCHRIFT

(11) **EP 3 588 715 B1**
(45) Veröffentlichungstag und Bekanntmachung des Hinweises auf die Patenterteilung: **11.05.2022**
(21) Anmeldenummer: 19181110.8
(22) Anmeldetag: 19.06.2019
(51) Int. Cl.: H02H 5/12, A41D 13/00, G01R 19/00, G08B 21/00, H04W 48/10

(54) **TRANSFORMATORPRÜFGERÄT MIT SCHUTZAUSRÜSTUNG GEGEN STROMSCHLAG**
TRANSFORMER TESTING DEVICE WITH PROTECTION AGAINST DISCHARGE
APPAREIL DE CONTRÔLE DE TRANSFORMATEUR POURVU D'ÉQUIPEMENT DE PROTECTION CONTRE LES CHOCS ÉLECTRIQUES

(30) Priorität: 21.06.2018 AT 505042018
(43) Veröffentlichungstag der Anmeldung: 01.01.2020
(73) Patentinhaber: Adaptive Regelsysteme Gesellschaft mbH, 5020 Salzburg (AT)
(72) Erfinder: Klapper, Ulrich, 6830 Rankweil (AT); de Villiers, Wernich, 6850 Dornbirn (AT)
(74) Vertreter: Patentanwälte Pinter & Weiss OG

(56) Entgegenhaltungen:
- DE-A1- 3 903 025
- US-A1- 2015 091 735
- US-A1- 2017 303 187

## Beschreibung

Die gegenständliche Erfindung betrifft eine Anordnung zum Prüfen eines Transformators durch eine Person mit einem Transformatorprüfgerät mit einem Notaus-Schalter, wobei das Transformatorprüfgerät mit dem Transformator verbunden ist, sowie ein entsprechendes Verfahren zum Prüfen eines Transformators durch eine Person.

Bei Arbeiten an elektrischen Anlagen ist es üblich einen Notaus vorzusehen, um im Falle der Berührung eines unter Spannung stehenden oder stromführenden Bauteils durch eine Person den Bauteil spannungsfrei zu schalten. Mit solchen Schutzvorrichtungen kann die Sicherheit von an unter Spannung stehenden Teilen oder stromführenden Teilen arbeitenden Personen vor Stromschlag durch unbeabsichtigten Kontakt erhöht werden, indem weitere anwesende Personen den Notaus im Fehlerfall auslösen. Das bedingt aber, dass sich zumindest eine weitere Person in der Nähe eines Stromunfalles aufhält und auch Kenntnis vom Stromunfalle erlangt, was aber nicht immer der Fall ist.

Elektrische Anlagen und Teile davon, beispielsweise ein Transformator, bedürfen einer regelmäßigen Überprüfung, Wartung und Instandhaltung, die von entsprechenden Personen durchgeführt wird, zum Teil auch während des laufenden Betriebs. Dabei bedient man sich auch sogenannter Transformatorprüfgeräte, die mit dem Transformator oder Teilen davon verbunden werden, um elektrische Ströme oder Spannungen einzuprägen. Solche Transformatorprüfgeräte können für eine Überprüfung selbst hohe elektrische Spannungen und/oder Ströme erzeugen. Damit geht bei solchen Prüfungen immer eine immanente Gefährdung der durchführenden Personen einher, da im Falle eines unbeabsichtigten Kontaktes mit stromführenden oder unter Spannung stehenden Teilen des Prüfgeräts durch Stromschlag Lebensgefahr oder zumindest die Gefahr von teils erheblichen Verletzungen bestehen kann. Auch in diesem Fall sind Notaus-Schalter am Transformatorprüfgerät eine übliche Maßnahme, um die Sicherheit zu erhöhen. Aber auch in diesem Fall bedingt das, dass sich zumindest eine weitere Person in der Nähe eines Stromunfalles aufhält und auch Kenntnis vom Stromunfalle erlangt, was aber nicht immer der Fall ist.

Es ist daher die Aufgabe der gegenständlichen Erfindung die Sicherheit gegen Stromschläge bei Verwendung eines Transformatorprüfgeräts durch eine Person zu erhöhen.

Diese Aufgabe wird erfindungsgemäß mit den kennzeichnenden Merkmalen von Ansprüchen 1 bzw. 13 gelöst. Damit ist die Betätigung des Notaus nicht mehr allein an einer weiteren Person, die den Notaus betätigen kann, gebunden, sondern der Notaus kann auch von extern über den Notsignaleingang aktiviert werden. Damit erhält das Transformatorprüfgerät einen zusätzlichen Schutzeingang, der anwendungsspezifisch beschaltet werden kann, um die Sicherheit der mit dem Transformatorprüfgerät oder an einem damit verbundenen Transformator arbeitenden Person zu erhöhen.

Das Notsignal wird mit einer Schutzvorrichtung zum Erkennen eines elektrischen Körperstroms erzeugt, die von der Person getragen wird, und die im Falle eines detektierten Körperstroms ein Notsignal ausgibt und an den Notsignaleingang des Transformatorprüfgerätes übermittelt. Sobald die Schutzvorrichtung einen unzulässigen Körperstrom durch die Person detektiert (was entsprechend konfiguriert werden kann), wird ein Notsignal ausgelöst, das wiederum den Notaus des Transformatorprüfgerätes betätigt. Auf diese Weise ist der Schutz der Person nicht mehr an die Anwesenheit einer anderen Person gebunden.

Durch die gleichzeitige Erfassung der Position oder des Ortes der Person ist auch der Ort oder die Position bekannt, womit im Falle eines Stromunfalles rascher Hilfe geleistet werden kann.

Weitere vorteilhafte Ausgestaltungen und Wirkungen der Erfindung ergeben sich aus den abhängigen Ansprüchen und der nachfolgenden Beschreibung.

Die gegenständliche Erfindung wird nachfolgend unter Bezugnahme auf die Figuren 1 bis 8 näher erläutert, die beispielhaft, schematisch und nicht einschränkend vorteilhafte Ausgestaltungen der Erfindung zeigen. Dabei zeigt
Fig.1 einen mit einem Transformatorprüfgerät verbundenen Transformator,
Fig.2 die Einbindung eines Notsignaleingangs zum Empfangen eines Notsignals in das Transformatorprüfgerät,
Fig.3 eine von einer Person getragene Schutzvorrichtung,
Fig.4 ein Ausführungsbeispiel zum Verständigen einer entfernten Stelle über einen Stromunfall einer Person, die eine Schutzvorrichtung trägt,
Fig.5 die Verwendung eines mobilen Endgeräts für Herstellung der Funkverbindung zur entfernten Stelle,
Fig.6 die zusätzliche Erfassung der Position der Person,
Fig.7 eine mögliche Kommunikationsverbindung zwischen zwei Schutzvorrichtungen und
Fig.8 ein Transformatorprüfgerät mit mehreren Funkempfängern zum Empfangen des Notsignals von der Schutzvorrichtung.

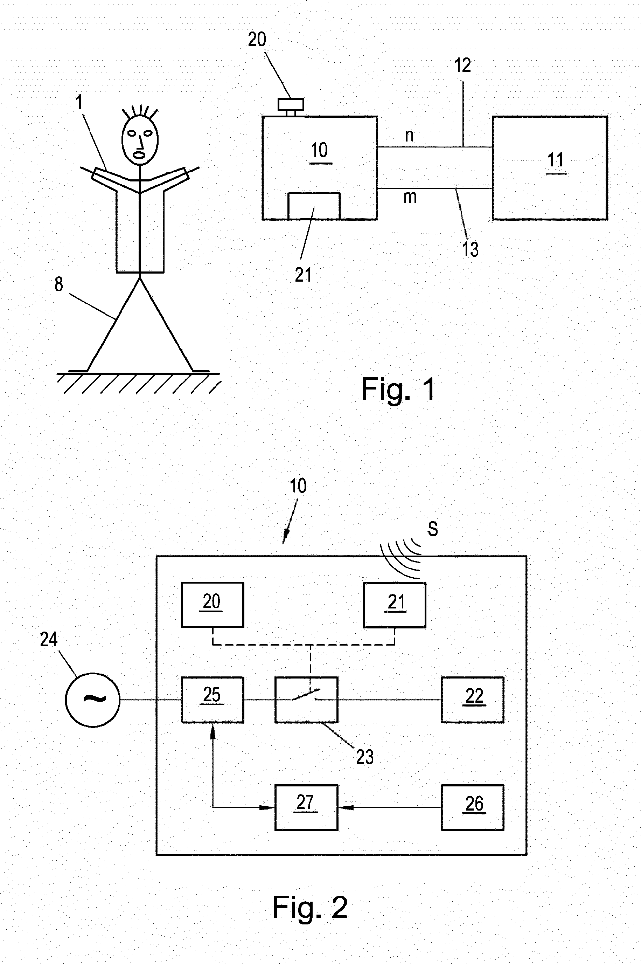

Ein Transformatorprüfgerät 10, wie in Fig.1 dargestellt, dient dazu ein- oder mehrphasige Wechsel- oder Gleichströme in Transformtoren 11 oder Teilen davon, beispielsweise einem Stufenschalter oder eine Wicklung, einzuprägen und/oder elektrische Spannungen daran anzulegen und dabei die Reaktion des Transformators 11 auf diese elektrischen Ströme und/oder Spannungen zu messen und auszuwerten. Dazu weist das Transformatorprüfgerät 10 einen Strom- und/oder Spannungsgenerator 25 (Fig.2) und damit verbundene oder verbindbare Strom- und Spannungsausgänge 22 auf, an die ein n-poliges Kabel 12 zum Verbinden des Transformatorprüfgeräts 10 mit dem Transformator 11, oder Teile davon, angeschlossen werden kann. Das Transformatorprüfgerät 10 ist dazu mit einer Energieversorgung 24 verbunden, die extern sein kann (beispielsweise ein elektrisches Netz oder eine externe Batterie, oder auch intern (z.B. im Falle eines batteriebetriebenen Gerätes). Zusätzlich sind am Transformatorprüfgerät 10 auch Signaleingänge 26 vorgesehen, über die die Reaktion des Transformators 11, beispielsweise in Form von Strömen, Spannungen oder anderen Messgrößen, im Transformatorprüfgerät 10 erfasst werden können. Die Signaleingänge 26 können ebenfalls über ein m-poliges Kabel 13 mit dem Transformator 11 oder Teilen davon verbunden werden. Das Transformatorprüfgerät 10 umfasst in der Regel auch eine Steuereinheit 27, über die eine Prüfung des Transformators 11 gesteuert werden kann, die als beispielsweise den Strom- und/oder Spannungsgenerator 25 zur Erzeugung benötigter Ströme und/oder Spannungen ansteuert und die die Reaktion des Transformators 11 ausgewertet werden kann.

Zum Schutz von Personen 8, die mit einem solchen Transformatorprüfgerät 10 an einem Transformator 11 arbeiten ist Transformatorprüfgerät 10 ein hinlänglich bekannter mechanischer Notaus-Schalter 20 vorgesehen. Der Notaus kann im Transformatorprüfgerät 10 wie in Fig.2 dargestellt realisiert sein. Im Transformatorprüfgerät 10 ist zwischen dem Strom- und/oder Spannungsgenerator 25 und den Strom- und Spannungsausgängen 22 eine Trenneinheit 23 vorgesehen. Die Trenneinheit 23 könnte aber auch vor dem Strom- und/oder Spannungsgenerator 25 vorgesehen sein, oder auch an einer anderen geeigneten Stelle im Transformatorprüfgerät 10. Die Trenneinheit 23 kann dabei natürlich auch mehrpolig ausgeführt sein, je nach der Anzahl der Strom- und Spannungsausgänge 22. Der Notaus-Schalter 20 aktiviert beim Betätigen die Trenneinheit 23, beispielsweise ein Trennrelais, im Transformatorprüfgerät 10, das die Strom- und Spannungsausgänge 22 des Transformatorprüfgeräts 10 strom- und spannungslos schaltet und/oder kurzschließt.

Der Notaus-Schalter 20 kann von der Person 8, oder einer anderen anwesenden Person, manuell betätigt werden, um die Ausgänge des Transformatorprüfgeräts 10 strom- und spannungslos zu schalten und/oder kurzzuschließen. Damit wird nicht die externe Energiezufuhr zum Transformatorprüfgerät 10 getrennt, sondern es werden die Ausgänge im Transformatorprüfgerät 10 selbst strom- und spannungslos geschaltet. Ein Ausschalten der Ausgänge ist schneller und sicherer, da ansonsten eventuell im Transformatorprüfgerät 10 vorhandene Kapazitäten die Ausgänge noch so lange speisen, bis die Energie aufgebraucht ist. Das kann in Transformatorprüfgeräten 10 durchaus im Bereich von einigen Sekunden sein. Trotz des Notaus-Schalters 20 kann sich für die Person 8 ein Gefährdungspotential durch unbeabsichtigtes Kontaktieren von stromführenden oder unter Spannung stehenden Teilen des Transformatorprüfgerätes 10 oder des Transformators 11 ergeben, insbesondere dann, wenn die Person 8 durch Stromschlag nicht mehr in der Lage ist, den Notaus selbst zu betätigen und keine andere Person anwesend ist oder den Stromunfall bemerkt. Außerdem dauert ein manuelles Ausschalten jedenfalls einige Sekunden, was die Dauer des Stromunfalles und damit die Gefährdung der verunfallten Person erheblich erhöht.

Daher ist am Transformatorprüfgerät 10 zusätzlich ein Notsignaleingang 21 vorgesehen ist, der bei Empfang eines externen Notsignals S die Trenneinheit 23 des Notaus-Kreises betätigt. Erfindungsgemäß ist folglich auch der Notsignaleingang 21 mit der Trenneinheit 23 verbunden und aktiviert die Trenneinheit 23 beim Empfang eines Notsignals S über den Notsignaleingang 21. Es könnten aber natürlich im Transformatorprüfgerät 10 gleichwirkend auch mehrere seriell geschaltete Trenneinheiten 23 vorgesehen sein, die jeweils separat angesteuert werden, beispielsweise eine Trenneinheit für den Notaus-Schalter 20 und eine Trenneinheit 23 für den Notsignaleingang 21.

Um ein Notsignal S im Falle eines Stromunfalles zu erzeugen kann die Person 8 zusätzlich mit einer Schutzvorrichtung 1 gegen Stromschlag ausgestattet sein. Eine solche Schutzvorrichtung ist an sich in ihrer grundlegenden Funktion aus dem Stand der Technik bekannt. Beispielsweise beschreibt die DE 39 03 025 A1 eine solche Schutzvorrichtung, wobei an zumindest zwei Extremitäten der Person, z.B. Armen oder Beinen, jeweils eine Elektrode angeordnet ist, die mit einem Steuergerät verbunden sind. Über die Elektroden wird durch das Steuergerät ein Körperstrom durch Kontakt eines elektrischen Fremdpotentials erfasst. Wird ein solcher Stromfluss erkannt, so aktiviert das Steuergerät eine Abschalteinrichtung, mit der die weitere Stromzufuhr in die Kontaktstelle unterbrochen wird. Die Elektroden und das Steuergerät können dabei an einem Kleidungsstück angeordnet sein und die Verbindung zwischen Steuergerät und Abschalteinrichtung ist kabellos ausgeführt. Eine ähnliche Schutzvorrichtung zeigt auch die DE 44 38 063 A1.

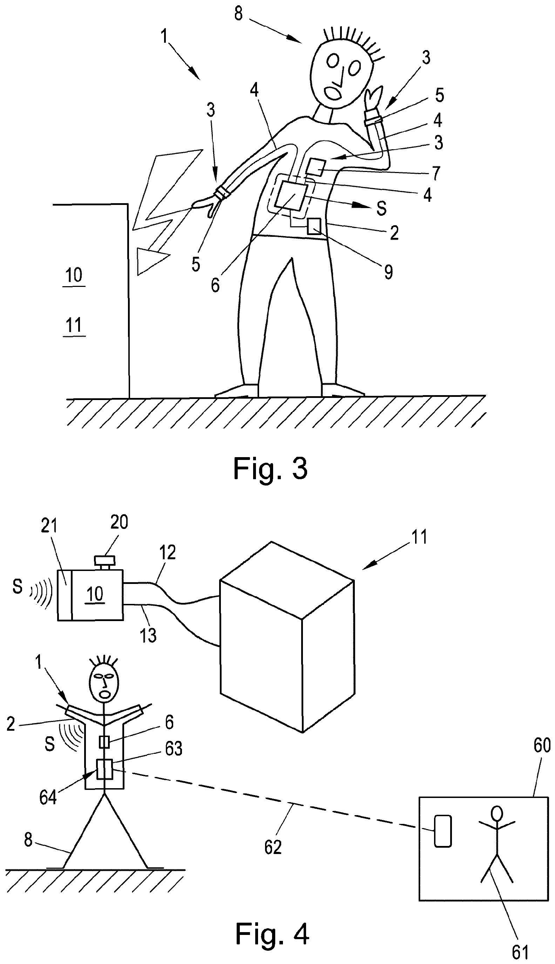

Die gegenständliche Erfindung nutzt eine Schutzvorrichtung 1 wie mit Bezugnahme auf die Fig.3 näher erläutert wird. Die Schutzvorrichtung 1, oder zumindest Teile davon, ist an einem Bekleidungsstück 2, hier ein Hemd, angeordnet oder integriert. Selbstverständlich kommen als Bekleidungsstück 2 auch andere Teile in Frage, z.B. eine Hose, ein Pullover, ein T-Shirt, eine Jacke, ein Overall, usw. Auch Kombinationen mehrerer Teile kommen als Bekleidungsstück 2 in Frage, z.B. eine Kombination aus Hose und Hemd, usw. Am Bekleidungsstück 2 ist zumindest ein Sensor 3 angeordnet, um einen durch den menschlichen Körper fließenden elektrischen Körperstrom zu detektieren. Als Sensor 3 kommen beispielsweise Elektroden 5 in Frage, um ein elektrisches Potential oder einen elektrischen Strom zu erfassen. Die Elektroden 5 sind vorzugsweise an exponierten Stellen des Bekleidungsstückes 2 angeordnet, beispielsweise im Bereich von Extremitäten, also beispielsweise an Ärmeln, Hosenbeinen oder Kapuzen. Als Sensor 3 kommt auch ein biometrischer Sensor 7 in Frage, um ein biometrisches Signal, beispielsweise die Frequenz des Herzschlages, die Amplitude oder den Verlauf des Herzschlages, die Atemfrequenz, den Hautwiderstand, usw., zu erfassen. Durch Auswertung des biometrischen Signals, insbesondere des Herzschlages (Frequenz, Amplitude und/oder Verlauf), kann ebenfalls auf einen fließenden elektrischen Körperstrom geschlossen werden.

Der Sensor 3, oder die Sensoren, kann dazu vorzugsweise im Bekleidungsstück 2 integriert sein, kann aber auch separat angelegt werden, beispielsweise mittels einer Manschette, eines Armbands oder eines Gurtes. In einer möglichen Ausführung könnte ein Sensor 3 als Elektrode 5 in Form einer bekannten Rogowski Spule ausgeführt sein (wie in Fig.3), um einen durch eine Extremität, oder anderen Teil des menschlichen Körpers, fließenden elektrischen Strom zu erfassen. Dazu kann die Elektrode 5 ringförmig um eine Extremität gelegt sein, z.B. in einem Bund eines Ärmels oder eines Hosenbeins des Bekleidungsstückes 2. Für die Erfassung eines elektrischen Potentials muss die Elektrode 5 elektrisch leitend an der Haut anliegen, während das z.B. im Falle einer Rogowski Spule nicht unbedingt erforderlich wäre. Um den Herzschlag zu erfassen könnte im Bekleidungsstück 2 ein entsprechender biometrischer Sensor 7, z.B. ein Herzfrequenzsensor, im Bekleidungsstück 2 im Bereich der Brust integriert sein, oder es könnte ein entsprechender Brustgurt angelegt werden.

Ein Sensor 3 ist über zumindest eine Signalleitungen 4 mit einer Auswerteeinheit 6 verbunden. In der Auswerteeinheit 6 werden die mit dem zumindest einen Sensor 3 erfassten Signale ausgewertet. Beispielsweise kann ein mit einer Elektrode 5 als Sensor 3 erfasstes elektrisches Potential oder ein erfasster fließender elektrischer Strom ausgewertet werden. Zwischen zwei erfassten elektrischen Potentialen, beispielsweise mit zwei als Elektroden 5 ausgeführten Sensoren 3, kann eine anliegende elektrische Spannung ermittelt und in der Auswerteeinheit 6 ausgewertet werden. Es kann auch zwischen zwei Elektroden 5 regelmäßig oder ständig eine Widerstandsmessung erfolgen, um zu prüfen ob das Kleidungsstück ordnungsgemäß mit dem Körper der Person 8 verbunden ist. Die Auswertung des Körperstroms oder Potentialunterschieds kann analog mit geeigneter Hardware oder digital, was eine A/D-Wandlung und entsprechende Hardware und Software erforderlich macht, erfolgen. Die Auswerteeinheit 6 erzeugt im Falle eines erkannten gefährlichen Körperstromes, beispielsweise eines abnormalen Herzschlages, eines erfassten gefährlichen Stromflusses oder einer gefährlichen Potentialdifferenz (Spannung) zwischen zwei Elektroden 5, was wiederum zu einem Stromfluss durch den Körper führt, ein Notsignal S, das genutzt werden kann, um eine gewünschte Aktion auszulösen. Hierzu können in der Auswerteeinheit 6 natürlich auch entsprechende Grenzwerte für einen zulässigen Körperstrom, beispielsweise eine zulässige Potentialdifferenz oder einen zulässigen Strom, hinterlegt oder vorgegeben werden, die auch änderbar sein können. Ebenso können in der Auswerteeinheit 6 auch Muster eines biometrischen Signals hinterlegt sein, die auf einen gefährlichen Körperstrom schließen lassen.

In vorteilhafter Weise können am Bekleidungsstück 2 verschiedene Sensoren 3 vorgesehen sein, um die Sicherheit der Erkennung von gefährlichen elektrischen Körperströmen zu erhöhen. Beispielsweise könnten Elektroden 5 an Extremitäten vorgesehen sein und zusätzlich ein biometrischer Sensor 7 zur Erfassung des Herzschlages, wie in Fig.3 dargestellt.

Ebenso kann durch Vorsehen von Redundanzen die Sicherheit der Schutzvorrichtung 1 erhöht werden. Beispielsweise kann pro Sensor 3 mehr als eine Signalleitung 4 vorgesehen sein, wodurch mögliche Kabelbrüche oder Kontaktfehler nicht zum Ausfall der Sicherheitsfunktion führen müssen oder ein Kabelbruch oder Kontaktfehler sogar erkannt, und gegebenenfalls auch angezeigt, werden kann.

Die Auswerteeinheit 6 wird vorzugsweise von der Person 8, die die Schutzvorrichtung 1 trägt, gehalten oder getragen. Beispielsweise könnte diese in einer Umhängetasche oder einem Rucksack angeordnet sein, könnte aber auch in einer Tasche des Bekleidungsstückes 2 gesteckt sein oder könnte vorteilhafterweise, ganz oder teilweise, auch im Bekleidungsstück 2 integriert sein, beispielsweise in Form eines intelligenten Kleidungstückes mit integrierter Elektronik.

Das Notsignal S kann grundsätzlich kabelgebunden oder kabellos (beispielsweise über eine Funkverbindung) ausgegeben werden und am Notsignaleingang 21 kabelgebunden oder kabellos empfangen werden.

Die Schutzvorrichtung 1 besteht somit beispielsweise aus einem Bekleidungsstück 2 mit zumindest einen Sensor 3 und einer Auswerteeinheit 6, die mit zumindest einer Signalleitung 4 mit dem zumindest einen Sensor 3 verbunden ist und die ein vom Sensor 3 erfasstes Signal auswertet, um einen gefährlichen elektrischen Körperstrom zu erfassen. Das Notsignal S der Auswerteeinheit 6 oder die Schutzvorrichtung 1 als solche kann nun auf verschiedenste Weise verwendet werden, um die Sicherheit einer Person 8 gegen Stromschlag zu erhöhen, wie nachfolgend im Detail ausgeführt.

In der Schutzvorrichtung 1, vorzugsweise am Bekleidungsstück 2 oder an einem externen Gerät, das in Datenverbindung mit der Schutzvorrichtung 1 steht, kann optional zumindest ein weiterer Sensor 9 zur Erfassung einer weiteren Größe vorgesehen sein, wobei mit der weiteren Größe ein weiterer Zustand der Person 8 (neben einem möglichen Körperstrom) erfasst wird. Der weitere Sensor 9 kann beispielsweise ein Beschleunigungssensor sein, um einen Fall der Person 8 feststellen zu können. Mittels eines Lagesensors als weiterer Sensor 9 kann erkannt werden, wenn die Person 8 liegt. Der weitere Sensor 9 kann zur Aufnahme eines EKG (Elektrokardiogramm) ausgestaltet sein, das in Zusammenhang mit einem Stromunfall wichtige Information über den Zustand der verunfallten Person 8 liefern kann. Mittels eines Beschleunigungssensors oder Bewegungssensors als weiterer Sensor 9 kann auch die Atmung der verunfallten Person 8 erfasst werden. Natürlich können auch mehrere weitere Sensoren 9 an der Schutzvorrichtung 1 vorgesehen sein, wobei beliebige Kombinationen der obigen Sensoren 9 denkbar sind.

Mit dem Sensor 3, oder den Sensoren 3, erfasste Werte und/oder mit dem zumindest einen weiteren Sensor 9 erfasste Werte können in der Schutzvorrichtung 1 in einer Speichereinheit, beispielsweise in der Auswerteeinheit 6, auch gespeichert werden. Das ermöglicht es gespeicherte Werte zu einem späteren Zeitpunkt auszulesen oder auch an andere Stellen zu übertragen.

Wird ein Kontakt der Person 8 mit einem stromführenden oder unter Spannung stehenden Teil, was einen durch die Person 8 fließenden Körperstrom verursacht, durch die Schutzvorrichtung 1 wie oben beschrieben detektiert, wird ein Notsignal S ausgelöst. Am Transformatorprüfgerät 10 ist zusätzlich ein Notsignaleingang 21 vorgesehen, der das Notsignal S empfängt und den Notaus des Transformatorprüfgerätes 10 aktiviert. Durch den Notaus werden die Strom- und Spannungsausgänge 22 des Transformatorprüfgerätes 10 strom- und spannungslos geschaltet und/oder kurzgeschlossen. Der Notsignaleingang 21 muss aber nicht zwingend in das Transformatorprüfgerät 10 integriert sein, sondern könnte auch als separate Einheit ausgeführt sein, die mit dem Transformatorprüfgerät 10 verbunden ist.

Die Schutzvorrichtung 1 kann aber noch zusätzliche Funktionen enthalten oder realisieren. Diese zusätzlichen Funktionen sind optional und können einzeln oder auch in beliebigen Kombinationen eingesetzt werden.

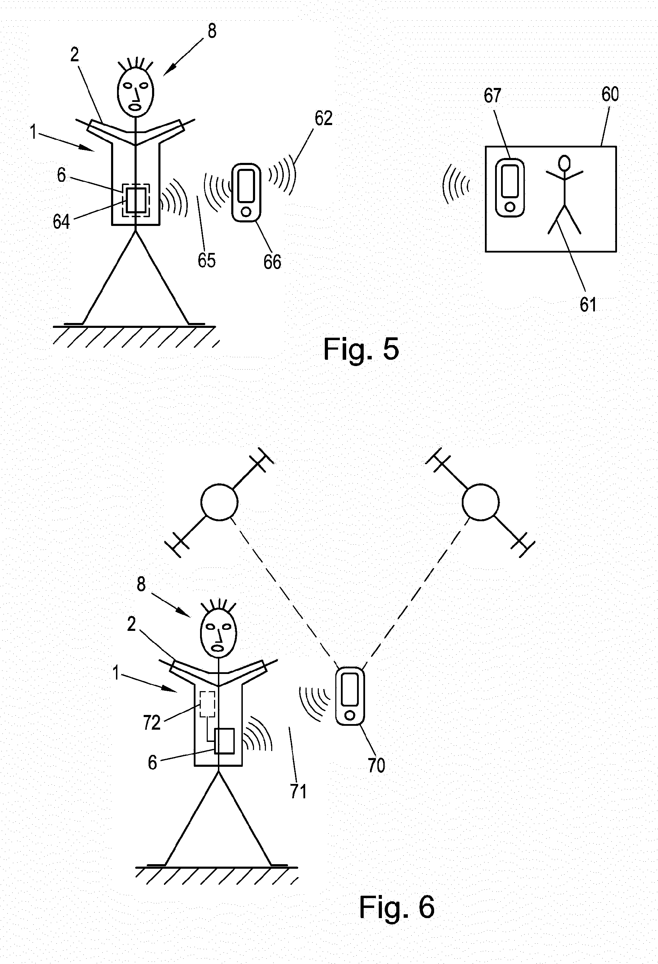

In vielen Situationen kann die Schutzvorrichtung 1 über einen Notsignaleingang 21 erfolgreich einen Notaus betätigen und damit Strom- und Spannungsausgänge 22 strom- und spannungslos schalten. Wenn die Schutzvorrichtung 1 aktiviert wird, ist es in diesen Situationen aber bereits zu einem Stromschlag gekommen. Die betroffene Person 8 kann aber mitunter an sehr entlegenen Stellen, beispielsweise an Energieversorgungsnetzen, oder alleine arbeiten, sodass trotz der Aktivierung der Schutzvorrichtung 1 keine Hilfe für die verunfallte Person 8 kommt. Dasselbe gilt, wenn die Schutzvorrichtung 1 aus welchen Gründen auch immer versagt, also die Schutzvorrichtung 1 zwar anspricht, aber keine Spannungsfreiheit hergestellt werden kann. Es kann daher vorgesehen sein, dass die Schutzvorrichtung 1 nicht nur ein Notsignal S erzeugt und ausgibt, sondern mit einer Sendeeinheit 64, wie z.B. ein Mobilfunksender 63, auch eine Funkverbindung 62 (angedeutet durch strichlierte Linie) zu einer konfigurierten entfernten Stelle 60 aufbaut und damit eine andere, entfernte Person 61 alarmiert, wie in Fig.4 dargestellt. "Entfernt" bedeutet in diesem Zusammenhang, dass diese weitere Person 61 zumindest so weit von der verunfallten Person 8 entfernt ist, dass diese weitere Person 61 den Zustand der verunfallten Person weder visuell noch akustisch unmittelbar wahrnehmen kann. Die weitere Person 61 kann beispielsweise in einer Notfallzentrale sitzen, die an einem gänzlich anderen Ort sein kann. Die Schutzvorrichtung 1 kann die Funkverbindung 62 über die Sendeeinheit 64 direkt aufbauen, beispielsweise mittels eines Mobilfunksenders 63, der im Bekleidungsstück 2 integriert ist, beispielsweise wieder als Teil einer intelligenten Kleidung. Alternativ kann die Schutzvorrichtung 1 die Funkverbindung 62 auch indirekt aufbauen, beispielsweise indem sich die Schutzvorrichtung 1 über die Sendeeinheit 64 über eine geeigneten Datenverbindung 65, beispielsweise Bluetooth, mit einem mobilen Endgerät 66 der Person 8, beispielsweise eine Smartphone, verbindet (z.B. mittels Bluetooth), das dann die Funkverbindung 62 zur entfernten Stelle 60 aufbaut, wie in Fig.5 dargestellt. Über die Funkverbindung 62 kann eine vorgegebene Nachricht gesendet werden, beispielsweise eine Textnachricht (z.B. per SMS), eine Datenübermittlung (z.B. per E-Mail) oder ein Anruf. Die weitere Person 61 in der entfernten Stelle 60 kann dabei ebenfalls ein mobiles Endgerät 67 bei sich tragen, das bei Bedarf mit der Funkverbindung 62 verbunden werden kann, beispielsweise über ein Mobilfunknetz. Es ist offensichtlich, dass die entfernte Stelle 60 (z.B. Notfallzentrale) nicht ortsgebunden sein muss, insbesondere, wenn die weitere Person 61 ebenfalls ein mobiles Endgerät 67 zur Kontaktierung verwendet.

Die Sendeeinheit 64, z.B. in Form eine Mobilfunksender 63, kann dabei in der Auswerteeinheit 6 oder auch im Bekleidungsstück 2 (beispielswiese in Form einer intelligenten Kleidung) selbst integriert sein. Die Sendeeinheit 64 kann von der Auswerteinheit 6 der Schutzvorrichtung 1 gesteuert sein.

Die weitere Person 61 kann dann Hilfe für die verunfallte Person 8 koordinieren. Beispielsweise kann in einer Notfallzentrale der Einsatzort von Personen 8, die an stromführenden oder unter Spannung stehenden Anlagen arbeiten, bekannt sein. Beispielsweise sind Wartungsarbeiten an einem Energieversorgungsnetz geplant und es ist bekannt, wann und wo diese durchgeführt werden. Die Schutzvorrichtung 1 kann einer bestimmten Person 8 zugeordnet sein und kann auch eine eindeutige Identifikation aufweisen (beispielsweise eine Mobilfunknummer). Damit kann in der Notfallzentrale ein eingehender Notruf von einer Schutzvorrichtung 1 einem Ort und/oder eine Person 8 zugeordnet werden, womit die Hilfe durch einen Helfer gezielt koordiniert werden kann.

Die Schutzvorrichtung 1 kann auch mit einer Einheit zur Positionsbestimmung ausgestattet sein. Dazu kann beispielsweise die Einheit 72 zur Positionsbestimmung, beispielsweise ein GPS (Global Positioning System) Sensor, am Bekleidungsstück 2 angeordnet werden (wie in Fig.6 strichliert angedeutet), oder in dieses integriert werden, beispielsweise in einer intelligenten Kleidung mit integrierter Elektronik. Selbstverständlich kommen dafür auch andere Satellitennavigationssysteme in Frage, wie beispielsweise GALILEO. Es gibt aber natürlich auch andere Möglichkeiten, die Position einer Person 8 mittels einer Einheit 72 zur Positionsbestimmung zu bestimmen. Beispielsweise könnte aus der Verfügbarkeit von WLAN (Wireless LAN) Netzen ein Rückschluss auf die aktuelle Position gezogen werden. Auch über ein Mobilfunknetz könnte eine Positionsbestimmung erfolgen, beispielsweise mittels GSM-Ortung.

Die Schutzvorrichtung 1 kann aber auch mit einem externen Gerät 70, welches eine Positionsbestimmung durchführen kann, als Einheit 72 zur Positionsbestimmung verbunden sein, wie beispielsweise in Fig.6 dargestellt. Heutige Mobiltelefone oder Smart Phones haben in der Regel eine Positionsbestimmung integriert. Damit kann die Schutzvorrichtung 1 mit dem externen Gerät 70 über eine Datenverbindung 71, beispielsweise Bluetooth, verbunden werden, um vom externen Gerät 70 die aktuelle Position der Person 8 zu erhalten. Zur Verbindung könnte in der Schutzvorrichtung 1 beispielsweise wieder eine Sendeeinheit 64 vorgesehen sein. Die aktuelle Position kann in der Schutzvorrichtung 1, vorzugsweise in der Auswerteinheit 6 der Schutzvorrichtung 1, gespeichert werden, vorzugsweise mit weiteren Details eines Stromunfalls, wie beispielsweise Datum, Uhrzeit, Dauer des Körperstromes, Höhe des Stromflusses, um eine spätere Auswertung zu ermöglichen. Unter aktueller Position werden hierbei sowohl Geokoordinaten verstanden, als auch ein konkreter Ort. Nachdem viele externe Geräte 70 häufig auch eine Ortungsfunktion besitzen, kann auch direkt der Ort als aktuelle Position verwendet werden.

Selbstverständlich kann die aktuelle Position oder der aktuelle Ort auch an eine entfernte Stelle 60 (wie in Fig.4 oder 5) übertragen werden, um die Koordination von Hilfe für die verunfallte Person 8 zu unterstützen. Die aktuelle Position oder der aktuelle Ort könnte auch in bestimmten Zeitabständen an die entfernte Stelle 60 übermittelt werden, um immer eine aktuelle Position oder einen aktuellen Ort der Person 8 zu kennen.

Es ist offensichtlich, dass bei der Benachrichtigung einer entfernten Stelle 60 von der Schutzvorrichtung 1 natürlich auch zusätzliche Information übertragen werden kann, beispielsweise Daten von weiteren Sensoren 9 an der Schutzvorrichtung 1 zum Zustand der Person 8, beispielsweise Lage der Person 8 (Fall, Person liegt), Puls, EKG, Atmung. Solche zusätzliche Information kann für die Koordination der Hilfe und den Rettungseinsatz wichtig sein.

Die entfernte Stelle 60 kann aber natürlich auch insofern automatisiert sein, dass im Falle einer eingehenden Nachricht eines Stromunfalls einer Person 8 automatisiert gewisse Handlungen gesetzt werden, beispielsweise die Verständigung eines Rettungsdienstes oder Helfers, eventuell auch mit der bestimmten Position oder den Ort der Person 8 und eventuell auch mit weiteren vorhandenen Daten.

Dazu könnte die entfernte Stelle 60 auch einen, oder auch mehrere, Helfer in der Nähe der verunfallten Person 8 ermitteln und diesen gezielt über den Stromunfall informieren. Dazu kann der Helfer mit einer Kommunikationseinheit, beispielsweise ein Mobiltelefon oder Smart Phone, ausgestattet sein, die von der entfernten Stelle 60 oder von einer weiteren Person 61 in der entfernten Stelle 60 mit einer entsprechenden Nachricht kontaktiert wird. Die Nachricht könnte eine SMS, E-Mail, oder ähnliches sein, oder auch ein Anruf.

Ein Helfer in der Nähe der verunfallten Person könnte dadurch ermittelt werden, dass in der entfernten Stelle 60 die Positionen aller in Frage kommenden Helfer bekannt sind. Beispielsweise könnten der entfernten Stelle 60 über die Kommunikationseinheiten der Helfer in vorgegebenen Abständen laufend die aktuellen Positionen übermittelt werden. Eine Nähe könnte aber auch so bestimmt werden, dass festgestellt wird, ob eine Kommunikationseinheit der verunfallten Person 8, beispielsweise ein mobiles Endgerät 66, mit einer Kommunikationseinheit eines Helfers Nachrichten austauschen können, beispielsweise über Bluetooth, oder ob beide das gleiche WLAN-Netz empfangen können. Das könnte der entfernten Stelle 60 auch von der jeweiligen Kommunikationseinheit laufend mitgeteilt werden, damit die entfernte Stelle 60 immer einen aktuellen Status hat.

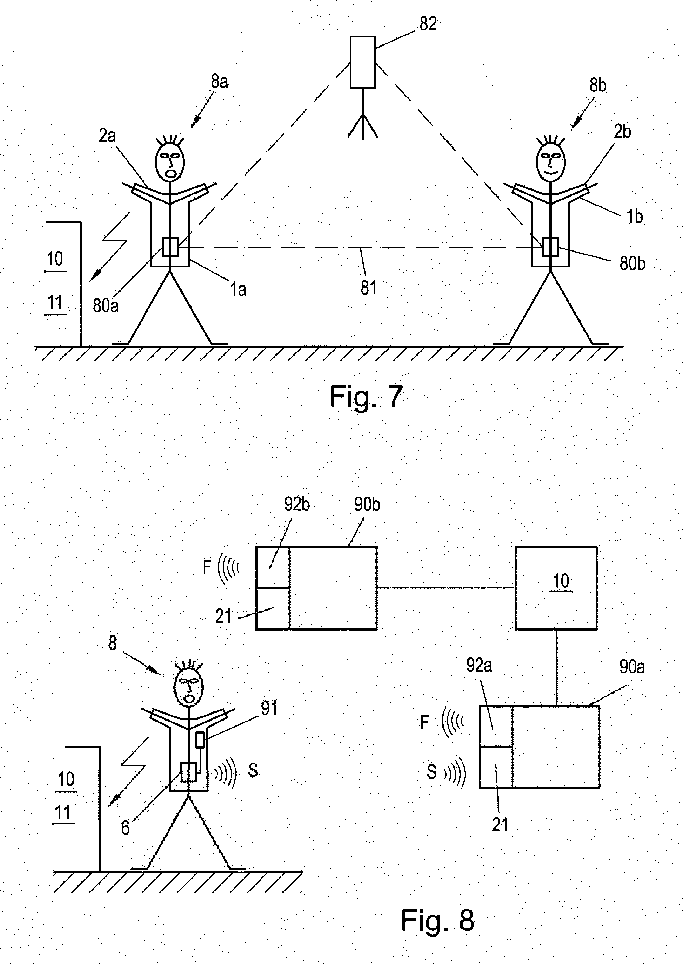

Es ist auch denkbar, dass sich zur Durchführung von Arbeiten an stromführenden Teilen der elektrischen Anlage 12 gleichzeitig mehrere Personen im Bereich der Arbeiten aufhalten. In solchen Situationen kann es vorkommen, dass ein Stromunfall einer Person 8 von anderen Personen im Umfeld, auch in unmittelbarer Nähe, nicht wahrgenommen wird. Dadurch können auch andere Personen in Gefahr kommen, beispielsweise, weil sie die im Stromkreis befindliche Person 8 berühren oder weil sie auch den unter Spannung stehenden Teil berühren. Abgesehen davon ist eine effiziente Handlung zur Rettung der verunfallten Person 8 oder der Schutz anderer Personen im Umfeld, beispielsweise durch Ausschalten oder Kurzschließen des Stromkreises oder auch durch Wegrempeln der verunfallten Person 8, nur dann möglich, wenn zumindest eine andere Person im Umkreis Kenntnis vom Stromunfall erlangen. Auch in solchen Fällen kann eine erfindungsgemäße Schutzvorrichtung 1 vorteilhaft eingesetzt werden, wie anhand der Fig.7 beispielhaft beschrieben wird.

Es wird dabei davon ausgegangen, dass sich mehrere Personen 8a, 8b mit jeweils einer Schutzvorrichtung 1a, 1b im Umfeld eines unter Spannung stehenden Bauteils befinden und dass die Schutzvorrichtungen 1a, 1b in Kommunikationsverbindung stehen. Dazu kann jede Schutzvorrichtung 1a, 1b mit einer Kommunikationseinheit 80a, 80b ausgeführt sein, um eine Kommunikationsverbindung 81, beispielsweise Bluetooth, aufbauen zu können. Die Kommunikationsverbindung 81 kann aber auch indirekt aufgebaut werden, beispielsweise so wie zu Fig.5 erläutert über ein mobiles Endgerät 66 einer Person 8a, 8b. Die Kommunikationseinheiten 80a, 80b der beiden Schutzvorrichtungen 1a, 1b müssen aber auch nicht unmittelbar miteinander kommunizieren. Denkbar wäre es beispielsweise, dass im Bereich der Arbeiten eine Kommunikationszentrale 82 aufgestellt wird, mit der sich die einzelnen Schutzvorrichtungen 1a, 1b über deren Kommunikationseinheiten 80a, 80b verbinden, wie in Fig.7 angedeutet. Die Kommunikationsverbindung 81 wird dann über die Kommunikationszentrale 82 hergestellt. Die Kommunikationsverbindung 81 kann permanent aufgebaut sein, oder kann auch anlassbezogen aufgebaut werden. Löst eine Schutzvorrichtung 1a einer Person 8a ein Notsignal S aus, weil diese Person 8a in einen Stromkreis gerät, so wird über die Kommunikationseinheit 80a der Schutzvorrichtung 1a die zumindest eine weitere Person 8b im Umkreis über die Kommunikationsverbindung 81 und die Kommunikationseinheit 80b der Schutzvorrichtung 1b darüber informiert. Dazu kann an einer Schutzvorrichtung 1 auch eine entsprechende Signalisierungseinheit, beispielsweise ein akustischer, visueller oder palpabler Alarm, vorgesehen sein. Wenn eine Schutzvorrichtung 1 zusätzlich mit einer eindeutigen Kennung versehen ist, kann zusätzlich auch noch übermittelt werden, welche Schutzvorrichtung 1 betroffen ist, um die verunfallte Person 8a leichter ausfindig machen zu können. Damit kann die Hilfe für eine verunfallte Person 8a erheblich beschleunigt werden.

Statt einer aufgestellten Kommunikationszentrale 82 im Bereich der Arbeiten könnte die beschriebene Kommunikation auch über eine (beliebig) weit entfernte Stelle 60 als Kommunikationszentrale, beispielsweise wie in Fig.4 oder 5 beschrieben, erfolgen.

Die Schutzvorrichtung 1 der verunfallten Person 8, bzw. eine Kommunikationseinheit 80 der Schutzvorrichtung 1 auch ein damit gekoppeltes externes Gerät 70, beispielsweise ein Mobiltelefon das die Person 8 mitführt, kann auch mit lautem akustischen Signal, optional auch mit gesprochenem Warntext, umgebende, eventuell auch ungeschulte und nicht ausgerüstete, Personen 8 auf die Gefahr und die benötigte Hilfe aufmerksam machen. Eine akustische Warnung wie "Achtung - Stromunfall - diese Person steht unter Spannung. Person nicht anfassen. Stromkreis unterbrechen oder Person vom Stromkreis wegrempeln" oder "Achtung - Stromunfall - diese Person hat einen elektrischen Schlag bekommen. Berührbare Teile unter Spannung sind in der Nähe" wäre beispielsweise denkbar.

Im Falle einer Funkverbindung zur Übermittlung des Ausgabesignals S von der Schutzvorrichtung 1 an einen Funkempfänger 90 mit einem Notsignaleingang 21, kann natürlich überprüft werden, entweder laufend oder zumindest zu Beginn der Arbeiten, ob überhaupt eine Funkverbindung besteht. Falls nicht, kann an der Schutzvorrichtung 1 ein entsprechender Alarm angezeigt werden, beispielsweise akustisch, visuell oder palpabel. Das gleiche gilt natürlich, wenn in der Schutzvorrichtung 1 ein niedriger Ladezustand einer Energieversorgung der Schutzvorrichtung 1 festgestellt wird.

In gewissen Anwendungen, insbesondere in Gebäuden kann die Funkverbindung zwischen der Schutzvorrichtung 1 und dem Funkempfänger zum Empfangen des Ausgabesignals, leicht und unerkannt abreißen, insbesondere wenn sich die Person, die die Schutzvorrichtung 1 trägt, bewegt. Das kann zu Fehlauslösungen führen, wenn ein fehlendes Funksignal im Funkempfänger eine Schalthandlung auslöst. Im schlimmsten Fall besteht für die tragende Person 8 durch die Schutzvorrichtung 1 unbemerkt kein Schutz mehr.

Ein Notsignaleingang 21 der mit Funk funktioniert könnte je nach Gefährlichkeit der Anwendung auch unterschiedlich konfiguriert werden, so dass eine Unterbrechung der Funkverbindung bei sehr gefährlicher Anwendung einen Ausschaltvorgang erzwingt, und bei weniger kritischen Anwendung dies nicht tut.

Abgesehen davon können im Arbeitsbereich der Person 8 räumlich verteilt zumindest zwei Funkempfänger 90a, 90b mit jeweils einem Notsignaleingang 21 zum Empfangen eines Notsignals S von der Schutzvorrichtung 1 vorgesehen sein, wie in Fig.8 dargestellt. Ein Funkempfänger 90a, 90b kann dabei wie oben beschrieben mit einem Transformatorprüfgerät 10 verwendet werden, um ein Notsignal S von der Schutzvorrichtung 1 zu erfassen und eine Handlung auszulösen. In diesem Fall wäre der Notsignaleingang 21 extern vom Transformatorprüfgerät 10 und das Transformatorprüfgerät 10 wäre mit dem externen Notsignaleingang 21 am Funkempfänger 90a, 90b verbunden. Die Schutzvorrichtung 1 steht in bidirektionaler Funkverbindung mit den Funkempfängern 90a, 90b. Das bedeutet, dass an der Schutzvorrichtung 1 ein Signalempfänger 91 vorgesehen sein muss, um ein Funksignal F, das von einem Sender 92a, 92b im Funkempfänger 90a, 90b ausgestrahlt wird, empfangen zu können. Der Signalempfänger 91 ist vorzugsweise am Bekleidungsstück 2 angeordnet oder in das Bekleidungsstück 2 integriert und mit der Auswerteeinheit 6, oder einer anderen Recheneinheit in der Schutzvorrichtung 1, verbunden. Das Funksignal F von einem Funkempfänger 90a, 90b wird dauernd oder zumindest in regelmäßigen Abständen ausgestrahlt, und wird vom Signalempfänger 91 der Schutzvorrichtung 1 empfangen. Die Schutzvorrichtung 1 ist damit in der Lage die Signalqualität des Funkkanals zwischen der Schutzvorrichtung 1 und einem Funkempfänger 90a, 90b auszuwerten. Damit kann die Schutzvorrichtung 1 entscheiden, über welchen der verfügbaren Funkkanäle das Notsignal S gesendet wird.

In einem Gebäude oder eine Anlage können verteilt eine Vielzahl solcher Funkempfänger 90a, 90b angeordnet sein und die Schutzvorrichtung 1 wählt jeweils einen Funkempfänger 90a, 90b aus, beispielsweise den Funkkanal mit der besten Signalqualität, um darüber das Notsignal S zu senden. Auf diese Weise kann sich die Person 8, die die Schutzvorrichtung 1 trägt, ohne Verlust der Funkverbindung durch das Gebäude oder die Anlage bewegen.

Für die Erfindung ist es aber prinzipiell unerheblich wo die Entscheidung getroffen wird über welchen Funkempfänger 90a, 90b kommuniziert werden soll. Die Entscheidung könnte im Signalempfänger 91, in den Funkempfängern 90a, 90b oder im Transformatorprüfgerät 10 oder auch anderswo getroffen werden.

## Patentansprüche

1. Anordnung zum Prüfen eines Transformators (11) durch eine Person (8), wobei die Anordnung ein Transformatorprüfgerät (10) und einen Transformator (11) umfasst, wobei das Transformatorprüfgerät (10) mit dem Transformator (11) verbunden ist und das Transformatorprüfgerät (10) einen Notaus-Schalter (20) umfasst, **dadurch gekennzeichnet, dass** die Anordnung weiters eine Schutzvorrichtung (1) zum Erkennen eines elektrischen Körperstroms umfasst, wobei die Person (8) die Schutzvorrichtung (1) zum Erkennen eines elektrischen Körperstroms trägt und die Schutzvorrichtung (1) ein Bekleidungsstück (2) und eine Auswerteeinheit (6) umfasst, wobei die Person (8) das Bekleidungsstück (2) trägt und das Bekleidungsstück (2) mit zumindest einem Sensor (3) zum Detektieren des Körperstromes ausgestattet ist, und die Auswerteeinheit (6) ein mit dem zumindest einen Sensor (3) erfasstes Signal auswertet und im Falle eines detektierten unzulässigen Körperstroms ein Notsignal (S) ausgibt, **dass** der Notaus-Schalter (20) bei Betätigung eine Trenneinheit (23) des Transformatorprüfgeräts (10) aktiviert, die zumindest einen Ausgang des Transformatorprüfgeräts (10) spannungsfrei schaltet und/oder kurzschließt und am Transformatorprüfgerät (10) zusätzlich ein Notsignaleingang (21) vorgesehen ist, der bei Empfang eines externen Notsignals (S) am Notsignaleingang (21) die Trenneinheit (23) aktiviert, **und dass** die Auswerteeinheit (6) im Falle eines detektierten unzulässigen Körperstroms das Notsignal (S) an den Notsignaleingang (21) des Transformatorprüfgerätes (10) übermittelt.

2. Anordnung nach Anspruch 1, **dadurch gekennzeichnet, dass** die Schutzvorrichtung (1) eine Einheit (72) zur Positionsbestimmung oder der Ortsbestimmung der Person (8) umfasst.

3. Anordnung nach Anspruch 1, **dadurch gekennzeichnet, dass** die Schutzvorrichtung (1), vorzugsweise das Bekleidungsstück (2), zumindest einen weiteren Sensor (9) umfasst, der einen weiteren Zustand der die Schutzvorrichtung (1) tragenden Person (8) erfasst.

4. Anordnung nach einem der Ansprüche 1 bis 3, **dadurch gekennzeichnet, dass** eine entfernte Stelle (60) vorgesehen ist, die im Falle eines Stromunfalls von der Schutzvorrichtung (1) informiert wird.

5. Anordnung nach Anspruch 2 und 4 und/oder 3 und 4, **dadurch gekennzeichnet, dass** die Schutzvorrichtung (1) der entfernten Stelle (60) auch Daten des zumindest einen weiteren Sensors (9) und/oder die Position oder den Ort der Person (8) übermittelt.

6. Anordnung nach Anspruch 4 oder 5, **dadurch gekennzeichnet, dass** die entfernte Stelle (60) einen Helfer kontaktiert und über den Stromunfall informiert.

7. Anordnung nach einem der Ansprüche 1 bis 6, **dadurch gekennzeichnet, dass** sich im Bereich der Arbeiten durch die Person (8a) zumindest eine weitere Person (8b) aufhält, die ebenfalls eine Schutzvorrichtung (1b) trägt, wobei die Schutzvorrichtung (1a) der Person (8a) und die Schutzvorrichtung (1b) der zumindest einen weiteren Person (8b) in Kommunikationsverbindung (81) sind, wobei die Schutzvorrichtung (1a) der Person (8a) die Schutzvorrichtung (1b) der zumindest einen weiteren Person (8b) über die Kommunikationsverbindung (81) über einen Stromunfall der Person (8) informiert.

8. Anordnung nach Anspruch 7, **dadurch gekennzeichnet, dass** die Schutzvorrichtungen (1a, 1b) jeweils eine Kommunikationseinheit (80a, 80b) zur Herstellung der Kommunikationsverbindung (81) umfassen.

9. Anordnung nach Anspruch 8, **dadurch gekennzeichnet, dass** im Bereich der Arbeiten der Person (8) eine Kommunikationszentrale (82) vorgesehen ist, die mit den Kommunikationseinheiten (80a, 80b) verbunden ist, um die Kommunikationsverbindung (81) herzustellen.

10. Anordnung nach einem der Ansprüche 1 bis 9, **dadurch gekennzeichnet, dass** die Schutzvorrichtung (1) im Falle eines Stromunfalls eine akustische Warnung und/oder einen akustischen Warntext ausgibt.

11. Anordnung nach einem der Ansprüche 1 bis 10, **dadurch gekennzeichnet, dass** die Schutzvorrichtung (1) das Notsignal (S) über Funk an den Notsignaleingang (21) überträgt und im Falle einer fehlenden Funkverbindung einen Alarm ausgibt.

12. Anordnung nach einem der Ansprüche 1 bis 11, **dadurch gekennzeichnet, dass** das Transformatorprüfgerät (10) mit mehreren Funkempfängern (90a, 90b) mit jeweils einem Notsignaleingang (21) verbunden ist, wobei die Schutzvorrichtung (1) einen Signalempfänger (91) umfasst, der ein vom Funkempfänger (90a, 90b) ausgestrahltes Funksignal (F) empfängt, womit über das Funksignal (F) die Signalqualität eines Funkkanals zwischen der Schutzvorrichtung (1) und einem Funkempfänger (90a, 90b) auswertbar und derjenige Funckanal mit der besten Signalqualität zum Senden eines Notsignals (S) auswählbar ist.

13. Verfahren zum Prüfen eines Transformators (11) durch eine Person (8) mit einem Transformatorprüfgerät (10) mit einem Notaus-Schalter (20), wobei das Transformatorprüfgerät (10) mit dem Transformator (11) verbunden wird, **dadurch gekennzeichnet, dass** die Person (8) eine Schutzvorrichtung (1) zum Erkennen eines elektrischen Körperstroms trägt und die Schutzvorrichtung (1) ein Bekleidungsstück (2) und eine Auswerteeinheit (6) umfasst, wobei die Person (8) das Bekleidungsstück (2) trägt und das Bekleidungsstück (2) mit zumindest einem Sensor (3) den Körperstrom detektiert und die Auswerteeinheit (6) ein mit dem zumindest einen Sensor (3) erfasstes Signal auswertet und im Falle eines detektierten unzulässigen Körperstroms ein Notsignal (S) ausgibt, **dass** bei Betätigung des Notaus-Schalters (20) eine Trenneinheit (23) des Transformatorprüfgeräts (10) aktiviert wird, mit der zumindest ein Ausgang des Transformatorprüfgeräts (10) spannungsfrei geschaltet und/oder kurzgeschlossen wird und die Trenneinheit (23) aktiviert wird, wenn ein externes Notsignal (S) an einem Notsignaleingang (21) des Transformatorprüfgeräts (10) empfangen wird, **und dass** im Falle eines detektierten unzulässigen Körperstroms von der Auswerteeinheit (6) das Notsignal (S)an den Notsignaleingang (21) des Transformatorprüfgerätes (10) übermittelt wird.

14. Verfahren nach Anspruch 13, **dadurch gekennzeichnet, dass** von der Schutzvorrichtung (1) mit einer Einheit (72) zur Positionsbestimmung oder der Ortsbestimmung die Position oder den Ort der Person (8) erfasst wird.

15. Verfahren nach Anspruch 13 oder 14, **dadurch gekennzeichnet, dass** von der Schutzvorrichtung (1) im Falle eines Stromunfalls eine entfernte Stelle (60) informiert wird.

16. Verfahren nach Anspruch 15, **dadurch gekennzeichnet, dass** die Schutzvorrichtung (1) der entfernten Stelle (60) auch Daten zumindest einen weiteren Sensors (9) an der Schutzvorrichtung (1) und/oder die Position oder den Ort der Person (8) übermittelt.

17. Verfahren nach Anspruch 15 oder 16, **dadurch gekennzeichnet, dass** die entfernte Stelle (60) einen Helfer kontaktiert und über den Stromunfall informiert.

18. Verfahren nach einem der Ansprüche 13 bis 17, **dadurch gekennzeichnet, dass** sich im Bereich der Arbeiten durch die Person (8a) zumindest eine weitere Person (8b) aufhält, die ebenfalls eine Schutzvorrichtung (1b) trägt, wobei zwischen der Schutzvorrichtung (1a) der Person (8a) und der Schutzvorrichtung (1b) der zumindest einen weiteren Person (8b) eine Kommunikationsverbindung (81) aufgebaut wird, wobei die Schutzvorrichtung (1a) der Person (8a) die Schutzvorrichtung (1b) der zumindest einen weiteren Person (8b) über die Kommunikationsverbindung (81) über einen Stromunfall der Person (8a) informiert.

19. Verfahren nach einem der Ansprüche 13 bis 18, **dadurch gekennzeichnet, dass** die Schutzvorrichtung (1) im Falle eines Stromunfalls eine akustische Warnung und/oder einen akustischen Warntext ausgibt.

20. Verfahren nach einem der Ansprüche 13 bis 19, **dadurch gekennzeichnet, dass** die Schutzvorrichtung (1) das Notsignal (S) über Funk an den Notsignaleingang (21) überträgt und im Falle einer fehlenden Funkverbindung einen Alarm ausgibt.

21. Verfahren nach einem der Ansprüche 13 bis 20, **dadurch gekennzeichnet, dass** das Transformatorprüfgerät (10) mit mehreren Funkempfängern (90a, 90b) mit jeweils einem Notsignaleingang (21) verbunden wird, wobei die Schutzvorrichtung (1) einen Signalempfänger (91) umfasst, der ein vom Funkempfänger (90a, 90b) ausgestrahltes Funksignal (F) empfängt und über das Funksignal (F) die Signalqualität eines Funkkanals zwischen der Schutzvorrichtung (1) und einem Funkempfänger (90a, 90b) ausgewertet wird und derjenige Funckanal mit der besten Signalqualität zum Senden eines Notsignals (S) ausgewählt wird.

## Claims

1. Arrangement for the testing of a transformer (11) by a person (8), the arrangement comprising a transformer testing device (10) and a transformer (11), the transformer testing device (10) being connected to the transformer (11) and the transformer testing device (10) comprising an emergency stop switch (20), **characterized in that** the arrangement further comprises a protective device (1) for detecting an electrical body current, with the person (8) wearing the protective device (1) for detecting an electrical body current and the protective device (1) comprising an item of clothing (2) and an evaluation unit (6), whereas the person (8) wears the item of clothing (2) and the item of clothing (2) being equipped with at least one sensor (3) for detecting the body current, and the evaluation unit (6) evaluats a signal detected with the at least one sensor (3) and, if an impermissible body current is detected, outputs an emergency signal (S), **in that** the emergency stop switch (20) activates a disconnection unit (23) of the transformer testing device (10) when actuated, which unit shuts down and/or short-circuits at least one output of the transformer testing device (10), and an emergency signal input (21) is also provided on the transformer testing device (10), which input activates the disconnection unit (23) when an external emergency signal (S) is received at the emergency signal input (21), **and in that** the evaluation unit (6) transmits the emergency signal (S) to the emergency signal input (21) of the transformer testing device (10) if an impermissible body current is detected.

2. Arrangement according to claim 1, **characterized in that** the protective device (1) comprises a unit (72) for determining the position or location of the person (8).

3. Arrangement according to claim 1, **characterized in that** the protective device (1), preferably the item of clothing (2), comprises at least one further sensor (9) that detects a further state of the person (8) wearing the protective device (1).

4. Arrangement according to any of claims 1 to 3, **characterized in that** a remote location (60) is provided, which is informed by the protective device (1) in the event of an electrical accident.

5. Arrangement according to claim 2 and 4 and/or 3 and 4, **characterized in that** the protective device (1) also transmits data from the at least one further sensor (9) and/or the position or location of the person (8) to the remote location (60).

6. Arrangement according to claim 4 or 5, **characterized in that** the remote location (60) contacts a helper and informs said helper about the electrical accident.

7. Arrangement according to any of claims 1 to 6, **characterized in that** at least one further person (8b) who is also wearing a protective device (1b) is in the area where the person (8a) is working, the protective device (1a) of the person (8a) and the protective device (1b) of the at least one further person (8b) having a communication link (81), the protective device (1a) of the person (8a) informing the protective device (1b) of the at least one further person (8b) about an electrical accident of the person (8) via the communication link (81).

8. Arrangement according to claim 7, **characterized in that** the protective devices (1a, 1b) each comprise a communication unit (80a, 80b) for establishing the communication link (81).

9. Arrangement according to claim 8, **characterized in that** a communication center (82) is provided in the area where the person (8) is working, which center is connected to the communication units (80a, 80b) in order to establish the communication link (81).

10. Arrangement according to any of claims 1 to 9, **characterized in that** the protective device (1) outputs an acoustic warning and/or acoustic warning text in the event of an electrical accident.

11. Arrangement according to any of claims 1 to 10, **characterized in that** the protective device (1) transmits the emergency signal (S) by radio to the emergency signal input (21) and outputs an alarm if there is no radio connection.

12. Arrangement according to any of claims 1 to 11, **characterized in that** the transformer testing device (10) is connected to a plurality of radio receivers (90a, 90b) each having an emergency signal input (21), the protective device (1) comprising a signal receiver (91) that receives a radio signal (F) transmitted by the radio receiver (90a, 90b), whereby the signal quality of a radio channel between the protective device (1) and a radio receiver (90a, 90b) can be evaluated via the radio signal (F), and the radio channel with the best signal quality for sending an emergency signal (S) can be selected.

13. Method for the testing of a transformer (11) by a person (8) using a transformer testing device (10) having an emergency stop switch (20), the transformer testing device (10) being connected to the transformer (11), **characterized in that** the person (8) wears a protective device (1) for detecting an electrical body current and the protective device (1) comprises an item of clothing (2) and an evaluation unit (6), whereas the person (8) wears the item of clothing (2) and the item of clothing (2) detects the body current with at least one sensor (3) and the evaluation unit (6) evaluats a signal detected with the at least one sensor (3) and, if an impermissible body current is detected, outputts an emergency signal (S), **in that** a disconnection unit (23) of the transformer testing device (10) is activated when the emergency stop switch (20) is actuated, by means of which unit at least one output of the transformer testing device (10) is shut down and/or short-circuited, and the disconnection unit (23) is activated when an external emergency signal (S) is received at an emergency signal input (21) of the transformer testing device (10), **and in that** the evaluation unit (6) transmits the emergency signal (S) to the emergency signal input (21) of the transformer testing device (10) if an impermissible body current is detected.

14. Method according to claim 13, **characterized in that** the position or location of the person (8) is detected by the protective device (1) using a unit (72) for determining position or location.

15. Method according to claim 13 or 14, **characterized in that** the protective device (1) informs a remote location (60) in the event of an electrical accident.

16. Method according to claim 15, **characterized in that** the protective device (1) also transmits data from at least one further sensor (9) on the protective device (1) and/or the position or location of the person (8) to the remote location (60).

17. Method according to claim 15 or 16, **characterized in that** the remote location (60) contacts a helper and informs said helper of the electrical accident.

18. Method according to any of claims 13 to 17, **characterized in that** at least one further person (8b) who is also wearing a protective device (1b) is in the area where the person (8a) is working, whereas a communication link (81) is established between the protective device (1a) of the person (8a) and the protective device (1b) of the at least one further person (8b), whereas the protective device (1a) of the person (8a) informs the protective device (1b) of the at least one further person (8b) about an electrical accident of the person (8a) via the communication link (81).

19. Method according to any of claims 13 to 18, **characterized in that** the protective device (1) outputs an acoustic warning and/or acoustic warning text in the event of an electrical accident.

20. Method according to any of claims 13 to 19, **characterized in that** the protective device (1) transmits the emergency signal (S) by radio to the emergency signal input (21) and outputs an alarm if there is no radio connection.

21. Method according to any of claims 13 to 20, **characterized in that** the transformer testing device (10) is connected to a plurality of radio receivers (90a, 90b) each having an emergency signal input (21), the protective device (1) comprising a signal receiver (91) that receives a radio signal (F) transmitted by the radio receiver (90a, 90b), and the signal quality of a radio channel between the protective device (1) and a radio receiver (90a, 90b) is evaluated via the radio signal (F), and the radio channel with the best signal quality for sending an emergency signal (S) is selected.

## Revendications

1. Agencement permettant de faire tester un transformateur (11) par une personne (8), l'agencement comprenant un appareil de test de transformateur (10) et un transformateur (11), l'appareil de test de transformateur (10) étant connecté au transformateur (11) et l'appareil de test de transformateur (10) comprenant un interrupteur d'arrêt d'urgence (20), **caractérisé en ce que** l'agencement comprend en outre un dispositif de protection (1) permettant de reconnaître un courant de choc électrique, la personne (8) portant le dispositif de protection (1) permettant de reconnaître un courant de choc électrique et le dispositif de protection (1) comprenant un vêtement (2) et une unité d'évaluation (6), la personne (8) portant le vêtement (2) et le vêtement (2) étant équipé d'au moins au moins un capteur (3) permettant de détecter le courant de choc, et l'unité d'évaluation (6) évaluant un signal détecté avec l'au moins un capteur (3) et, en cas de détection d'un courant de choc non autorisé, émet un signal d'urgence (S), **en ce que** l'interrupteur d'arrêt d'urgence (20) active une unité de déconnexion (23) de l'appareil de test de transformateur (10) lorsqu'il est actionné, laquelle met hors tension et/ou court-circuite au moins une sortie de l'appareil de test de transformateur (10), et une entrée de signal d'urgence (21) étant également prévue sur l'appareil de test de transformateur (10), laquelle active l'unité de déconnexion (23) à la réception d'un signal d'urgence externe (S) au niveau de l'entrée de signal d'urgence (21), **et en ce que** l'unité d'évaluation (6) transmet le signal d'urgence (S) à l'entrée de signal d'urgence (21) de l'appareil de test de transformateur (10) en cas de détection d'un courant de choc non autorisé.

2. Agencement selon la revendication 1, **caractérisé en ce que** le dispositif de protection (1) comprend une unité (72) permettant de déterminer la position ou l'emplacement de la personne (8).

3. Agencement selon la revendication 1, **caractérisé en ce que** le dispositif de protection (1), de préférence le vêtement (2), comprend au moins un autre capteur (9) qui détecte un autre état de la personne (8) portant le dispositif de protection (1).

4. Agencement selon l'une des revendications 1 à 3, **caractérisé en ce qu'**un poste distant (60) est prévu, lequel est informé par le dispositif de protection (1) en cas d'accident électrique.

5. Agencement selon les revendications 2 et 4 et/ou 3 et 4, **caractérisé en ce que** le dispositif de protection (1) transmet également des données de l'au moins un autre capteur (9) et/ou la position ou l'emplacement de la personne (8) au poste distant (60).

6. Agencement selon la revendication 4 ou 5, **caractérisé en ce que** le poste distant (60) contacte un auxiliaire et l'informe de l'accident électrique.

7. Agencement selon l'une des revendications 1 à 6, **caractérisé en ce que** dans la zone de travail de la personne (8a) se trouve au moins une autre personne (8b) qui porte également un dispositif de protection (1b), le dispositif de protection (1a) de la personne (8a) et le dispositif de protection (1b) de l'au moins une autre personne (8b) étant en connexion de communication (81), le dispositif de protection (1a) de la personne (8a) informant le dispositif de protection (1b) de l'au moins une autre personne (8b) d'un accident électrique impliquant la personne (8) par l'intermédiaire de la connexion de communication (81).

8. Agencement selon la revendication 7, **caractérisé en ce que** les dispositifs de protection (1a, 1b) comprennent respectivement une unité de communication (80a, 80b) permettant d'établir la connexion de communication (81).

9. Agencement selon la revendication 8, **caractérisé en ce qu'**un centre de communication (82) est prévu dans la zone de travail de la personne (8), lequel est connecté aux unités de communication (80a, 80b) afin d'établir la connexion de communication (81).

10. Agencement selon l'une des revendications 1 à 9, **caractérisé en ce que** le dispositif de protection (1) émet un avertissement acoustique et/ou un texte d'avertissement acoustique en cas d'accident électrique.

11. Agencement selon l'une des revendications 1 à 10, **caractérisé en ce que** le dispositif de protection (1) transmet le signal d'urgence (S) par radio à l'entrée de signal d'urgence (21) et émet une alarme en cas d'absence de connexion radio.

12. Agencement selon l'une des revendications 1 à 11, **caractérisé en ce que** l'appareil de test de transformateur (10) est connecté à plusieurs récepteurs radio (90a, 90b) comportant respectivement une entrée de signal d'urgence (21), le dispositif de protection (1) comprenant un récepteur de signal (91) qui reçoit un signal radio (F) diffusé par le récepteur radio (90a, 90b), avec lequel la qualité de signal d'un canal radio entre le dispositif de protection (1) et un récepteur radio (90a, 90b) peut être évaluée par l'intermédiaire du signal radio (F) et ledit canal radio peut être sélectionné avec la meilleure qualité de signal pour l'envoi d'un signal d'urgence (S).

13. Procédé permettant de faire tester un transformateur (11) par une personne (8) comportant un appareil de test de transformateur (10) comportant un interrupteur d'arrêt d'urgence (20), l'appareil de test de transformateur (10) étant connecté au transformateur (11), **caractérisé en ce que** la personne (8) porte un dispositif de protection (1) permettant de détecter un courant de choc électrique et le dispositif de protection (1) comprend un vêtement (2) et une unité d'évaluation (6), la personne (8) portant le vêtement (2) et le vêtement (2) détectant le courant de choc au moyen d'au moins un capteur (3) et l'unité d'évaluation (6) évaluant un signal détecté avec l'au moins un capteur (3) et, en cas de détection d'un courant de choc non autorisé, émettant un signal d'urgence (S), **en ce que** lorsque l'interrupteur d'arrêt d'urgence est actionné (20), une unité de déconnexion (23) de l'appareil de test de transformateur (10) est activée, avec laquelle au moins une sortie de l'appareil de test de transformateur (10) est mise hors tension et/ou court-circuitée et l'unité de déconnexion (23) est activée lorsqu'un signal d'urgence (S) externe est reçu au niveau d'une entrée de signal d'urgence (21) de l'appareil de test de transformateur (10), **et en ce qu'**en cas de détection d'un courant de choc non autorisé, le signal d'urgence (S) est transmis de l'unité d'évaluation (6) à l'entrée de signal d'urgence (21) de l'appareil de test de transformateur (10).

14. Procédé selon la revendication 13, **caractérisé en ce que** le dispositif de protection (1) détecte la position ou l'emplacement de la personne (8) avec une unité (72) permettant de déterminer la position ou l'emplacement.

15. Procédé selon la revendication 13 ou 14, **caractérisé en ce que** le dispositif de protection (1) informe un poste distant (60) en cas d'accident électrique.

16. Procédé selon la revendication 15, **caractérisé en ce que** le dispositif de protection (1) transmet également des données d'au moins un autre capteur (9) sur le dispositif de protection (1) et/ou la position ou l'emplacement de la personne (8) au poste distant (60).

17. Procédé selon la revendication 15 ou 16, **caractérisé en ce que** le poste distant (60) contacte un auxiliaire et l'informe de l'accident électrique.

18. Procédé selon l'une des revendications 13 à 17, **caractérisé en ce que** dans la zone de travail de la personne (8a) se trouve au moins une autre personne (8b) qui porte également un dispositif de protection (1b), une connexion de communication (81) étant établie entre le dispositif de protection (1a) de la personne (8a) et le dispositif de protection (1b) de l'au moins une autre personne (8b), le dispositif de protection (1a) de la personne (8a) informant le dispositif de protection (1b) de l'au moins une autre personne (8b) d'un accident électrique impliquant la personne (8a) par l'intermédiaire de la connexion de communication (81).

19. Procédé selon l'une des revendications 13 à 18, **caractérisé en ce que** le dispositif de protection (1) émet un avertissement acoustique et/ou un texte d'avertissement acoustique en cas d'accident électrique.

20. Procédé selon l'une des revendications 13 à 19, **caractérisé en ce que** le dispositif de protection (1) transmet le signal d'urgence (S) par radio à l'entrée de signal d'urgence (21) et émet une alarme en cas d'absence de connexion radio.

21. Procédé selon l'une des revendications 13 à 20, **caractérisé en ce que l**'appareil de test de transformateur (10) est connecté à plusieurs récepteurs radio (90a, 90b) comportant respectivement une entrée de signal d'urgence (21), le dispositif de protection (1) comprenant un récepteur de signal (91) qui reçoit un signal radio (F) diffusé par le récepteur radio (90a, 90b) et la qualité de signal d'un canal radio entre le dispositif de protection (1) et un récepteur radio (90a, 90b) étant évaluée par l'intermédiaire du signal radio (F) et ledit canal radio étant sélectionné avec la meilleure qualité de signal pour l'envoi d'un signal d'urgence (S).
